# EUROPÄISCHE PATENTSCHRIFT

(11) **EP 1 451 596 B1**
(45) Veröffentlichungstag und Bekanntmachung des Hinweises auf die Patenterteilung: **23.03.2005**
(21) Anmeldenummer: 02787712.5
(22) Anmeldetag: 16.11.2002
(51) Int. Cl.: G01R 27/26, G01R 31/26, G01R 31/27, G01R 31/28

(54) **VERFAHREN ZUM NACHWEIS DER FUNKTIONSFÄHIGKEIT VON MEHREREN GLEICHEN PARALLEL ZUEINANDER UND ZU EINER MAGNETSPULE GESCHALTETEN Z-DIODEN**
METHOD FOR DETECTING THE OPERABILITY OF A NUMBER OF IDENTICAL ZENER DIODES THAT ARE CONNECTED IN PARALLEL TO ONE ANOTHER AND TO A SOLENOID
PROCEDE DE MISE EN EVIDENCE DE LA FONCTIONNALITE DE PLUSIEURS DIODES ZENER IDENTIQUES MONTEES MUTUELLEMENT EN PARALLELE ET COMMUTEES A UN SOLENOIDE

(30) Priorität: 30.11.2001 DE 10158869
(43) Veröffentlichungstag der Anmeldung: 01.09.2004
(73) Patentinhaber: Bosch Rexroth AG, 97816 Lohr am Main (DE)
(72) Erfinder: PANZER, Karlheinz, 97525 Schwebheim (DE); HARTMANN, Peter, 97816 Lohr-Ruppertshütten (DE)
(86) Internationale Anmeldenummer: PCT/EP2002/012860
(87) Internationale Veröffentlichungsnummer: WO 2003/046588

(56) Entgegenhaltungen:
- DE-B- 1 235 423
- DE-C- 3 917 706
- PAULUS E J: "Surge/noise suppression within electrical connectors" PROCEEDINGS OF THE ELECTRONIC COMPONENTS AND TECHNOLOGY CONFERENCE. WASHINGTON, MAY 1 - 4, 1994, NEW YORK, IEEE, US, Bd. CONF. 44, 1. Mai 1994 (1994-05-01), Seiten 239-247, XP010126325 ISBN: 0-7803-0914-6
- ANONYMOUS: "Low Current and Capacitance Measurement Technique. November 1975." IBM TECHNICAL DISCLOSURE BULLETIN, Bd. 18, Nr. 6, 1. November 1975 (1975-11-01), Seiten 1782-1783, XP002236006 New York, US

## Beschreibung

Die Erfindung betrifft ein Verfahren zum Nachweis der Funktionsfähigkeit von mehreren gleichen parallel zueinander und zu einer Magnetspule geschalteten Z-Dioden.

Elektrisch betätigte hydraulische oder pneumatische Ventile steuern ein hydraulisches oder pneumatisches Arbeitsmedium entsprechend der Größe eines elektrischen Eingangssignals. Das elektrische Eingangssignal ist einer Magnetspule zugeführt, die einen Anker entsprechend dem über die Magnetspule fließenden Strom auslenkt. Werden derartige Ventile in einer explosionsgefährdeten Umgebung eingesetzt, gelten besondere Sicherheitsvorschriften. Diese Vorschriften erfordern es unter anderem, daß bei einem Bruch einer zu der Magnetspule führenden Leitung die dabei entstehende Induktionsspannung auf einen ungefährlichen Wert begrenzt wird. Damit soll die Bildung von Funken verhindert werden, die zündfähige Gase zur Explosion bringen können. Zur Begrenzung der bei einem Kabelbruch auftretenden Induktionsspannung entsprechend den für explosionsgeschützte Betriebsmittel geltenden Vorschriften sind zwei oder drei Z-Dioden parallel zu einer Magnetspule geschaltet. Damit die Begrenzung der Induktionsspannung unabhängig von ihrer Polarität erfolgt, werden z. B. zwei gegensinnig in Reihe geschaltete Z-Dioden eingesetzt. Alternativ hierzu können auch bidirektionale Z-Dioden eingesetzt werden, die zwei gegensinnig in Reihe geschalteten einfachen Z-Dioden entsprechen. Die Z-Dioden sind räumlich so nahe wie möglich an der Magnetspule angeordnet. Entsprechend den Sicherheitsvorschriften ist die aus den Z-Dioden und der Magnetspule gebildete Parallelschaltung zusätzlich mit einer isolierenden Masse vergossen. Die vergossene Schaltung bildet einen elektrischen Zweipol, aus dem nur die beiden Anschlußleitungen nach außen führen. Für die Prüfung der Funktionsfähigkeit der parallel zu der Magnetspule geschalteten Z-Dioden stehen somit lediglich die beiden Anschlußleitungen des Zweipols als Meßpunkte zur Verfügung. Es ist nicht möglich, die Z-Dioden nach dem Einlöten in die Schaltungsanordnung und nach dem Vergießen einzeln auf ihre Funktionsfähigkeit zu prüfen.

Relevante Dokumente:
DE-B-1235423 beschreibt die Kapazitätsmessung von Tunnel-Dioden durch die Resonanzmethode.
DE-C-3917706 beschreibt die Ermittlung des Miller-Effekts (Messung der "Ersatz-Kapazitäten") eines Transistors.
In "Proceedings of the Electronic Components And Technology Conference", Washington, vom 1. - 4. Mai 1994, New York, IEEE, Seiten 239-247 wird das Zustandekommen der Kapazitäts-Wirkung einer Zener-Diode beschrieben.
Im IBM Technical Disclosure Bulletin 18(6), Seiten 1782-1783 wird die Kapazitätsmessung von Dioden beschrieben.

Der Erfindung liegt die Aufgabe zugrunde, ein Verfahren anzugeben, das eine Prüfung der Funktionsfähigkeit von parallel zu einer Magnetspule angeordneten und zusammen mit dieser vergossenen Z-Dioden ermöglicht.

Diese Aufgabe wird durch die im Anspruch 1 gekennzeichneten Merkmale gelöst. Das erfindungsgemäße Verfahren beruht auf einer Bestimmung der Kapazität der Z-Dioden durch Ermittlung der Gesamtkapazität des vergossenen Zweipols unter Berücksichtigung der elektrischen Werte der Magnetspule, insbesondere ihrer parasitären Kapazität. Die Kapazität einer Z-Diode besteht aus Sperrschicht- und Diffusionskapazität. Von diesen Kapazitäten ist die Sperrschichtkapazität für das erfindungsgemäße Verfahren dominierend. Defekte Z-Dioden weisen entweder einen Kurzschluß oder eine Unterbrechung auf, sie besit-zen daher keine meßbare Kapazität. Mit dem erfindungsgemäßen Verfahren läßt sich zwar nicht ermitteln, welche Z-Diode im Fehlerfall nicht funktionsfähig ist. Dies ist auch nicht erforderlich, da hier nur geprüft zu werden braucht, ob alle Z-Dioden funktionsfähig sind. Ist eine der Z-Dioden im Fehlerfall nicht funktionsfähig, z. B. weil sie nicht richtig eingelötet worden ist oder weil sie beim Einlöten oder dem darauf folgenden Vergießen beschädigt worden ist, ist die Schaltung nicht verwendungsfähig. Welche der Z-Dioden in diesem Fall nicht funktionsfähig ist, spielt dabei keine Rolle.

Vorteilhafte Weiterbildungen des erfindungsgemäßen Verfahrens sind in den Unteransprüchen gekennzeichnet. Die Kapazität der Sperrschicht der Z-Dioden kann auf verschiedene Weise ausgewertet werden. Bei dem im Anspruch 2 angegebenen Verfahren wird die Gesamtkapazität des aus den Z-Dioden und der Magnetspule gebildeten Zweipols gemessen. Diese setzt sich aus der Summe der Kapazitäten der Sperrschichten der einzelnen Z-Dioden sowie aus der Kapazität der Magnetspule zusammen. Damit die parallel zu den Z-Dioden liegende Induktivität der Magnetspule nicht das Meßergebnis verfälscht, wird die Meßfrequenz so hoch gewählt, daß die Induktivität der Magnetspule praktisch keinen Einfluß mehr auf das Ergebnis der Kapazitätsmessung hat. Bei hohen Werten der Meßfrequenz ist der Wechselstromwiderstand der parallel zu den Z-Dioden liegenden Induktivität der Magnetspule sehr groß und wirkt daher wie eine Unterbrechung der Verbindung zwischen den beiden Anschlußleitungen. Für dieses Verfahren ist deshalb ein Kapazitätsmeßgerät mit hoher Meßfrequenz in der Größenordnung von 1 MHz oder höher erforderlich. Derartige Meßgeräte sind jedoch sehr teuer. Bei dem im Anspruch 3 angegebenen Verfahren werden die Induktivität der Magnetspule und die Resonanzfrequenz des aus der Magnetspule und den parallel geschalteten Z-Dioden gebildeten Schwingkreises gemessen. Aus diesen Werten wird die Gesamtkapazität des Zweipols berechnet und hiervon die Kapazität der Magnetspule abgezogen. Das Ergebnis wird mit dem sich aus der Messung von einzelnen Z-Dioden vor dem Zusammenbau ergebenden Wert verglichen. Dieses Verfahren hat den Vorteil, daß für die Ermittlung der Gesamtkapazität keine Meßgeräte mit einer so hohen Meßfrequenz erforderlich sind wie bei der direkten Messung der Kapazität der Sperrschicht der Z-Dioden.

Das erfindungsgemäße Verfahren wird im Folgenden mit seinen weiteren Einzelheiten anhand von zwei in den Zeichnungen dargestellten elektrischen Schaltbildern näher erläutert. Es zeigen
- Figur 1: ein Schaltbild einer elektrischen Schaltungsanordnung in Form eines Zweipols, der aus einer Magnetspule und drei zu dieser parallel geschalteten bidirektionalen Z-Dioden gebildet ist,
- Figur 2: ein elektrisches Ersatzschaltbild der in der Figur 1 dargestellten Schaltung und
- Figur 3: das Schaltbild einer Anordnung zur Ermittlung der Resonanzfrequenz der in den Figuren 1 und 2 dargestellten Schaltungsanordnung.

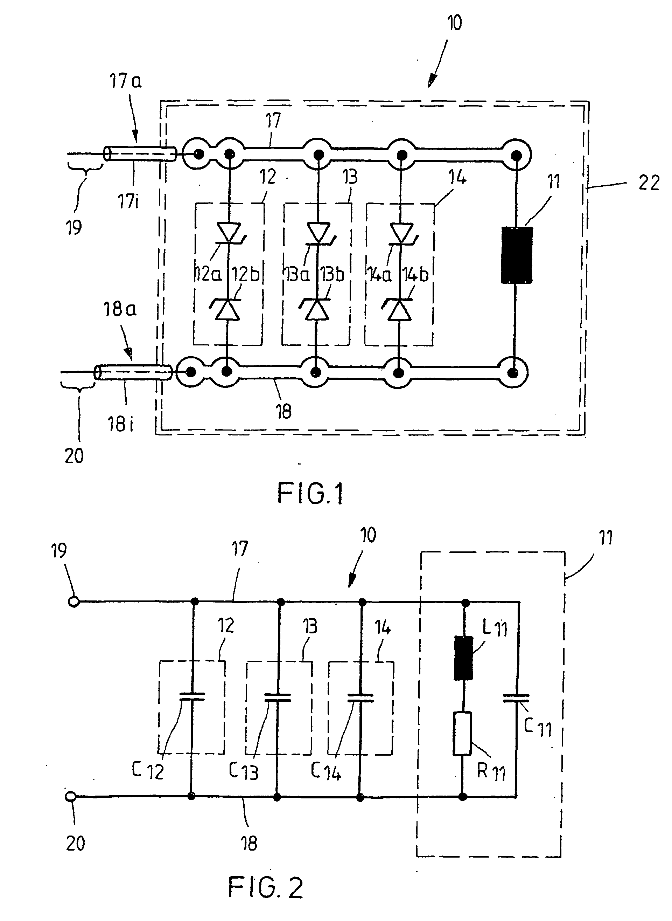

Die Figur 1 zeigt das Schaltbild einer elektrischen Schaltungsanordnung 10 in Form eines Zweipols. Sie besteht aus einer Magnetspule 11 sowie drei bidirektionalen Z-Dioden 12, 13 und 14, die parallel zu der Magnetspule 11 geschaltet sind. Je ein Anschluß dieser elektrischen Bauelemente ist an eine von zwei Leiterbahnen 17 bzw. 18 gelötet. An die Leiterbahnen 17 und 18 sind flexible elektrische Anschlußleitungen 17a bzw. 18a gelötet, die zum Anschluß der Schaltungsanordnung 10 an eine in den Figuren nicht dargestellte Steuerschaltung dienen, die die Magnetspule 11 im Betrieb mit Strom beaufschlagt. Die Litzen der Anschlußleitungen 17a und 18a sind mit einer elektrischen Isolierung 17i bzw. 18i versehen, die nur an den mit den Bezugszeichen 19 und 20 versehenen freien Enden entfernt ist. Die Schaltungsanordnung ist mit einem elektrisch isolierenden Kunststoff zu einem Block 22 vergossen, aus dem nur die isolierten Anschlußleitungen 17a und 18a herausragen. Bei den bidirektionalen Z-Dioden 12 bis 14 handelt es sich um elektrische Bauelemente, die jeweils zwei gleichen gegeneinander geschalteten einfachen Z-Dioden entsprechen. Der Verbindungspunkt der einzelnen Z-Dioden ist jedoch nicht zugänglich. Eine bidirektionale Z-Diode begrenzt eine an ihr anstehende Spannung unabhängig von der jeweiligen Stromrichtung auf einen Wert, der gleich der Summe aus der Begrenzungsspannung der einen Z-Diode und der Durchlaßspannung der jeweils anderen Z-Diode ist, sofern die zugeführte Spannung betragsmäßig größer als die Summe der Durchbruchspannung und der Durchlaßspannung der gegeneinander geschalteten Z-Dioden ist. In der Figur 1 sind die beiden Z-Dioden einer bidirektionalen Z-Diode durch die an das Bezugszeichen der jeweiligen bidirektionalen Z-Diode angefügten Buchstaben a oder b versehen.

Die Figur 2 zeigt ein elektrisches Ersatzschaltbild der in der Figur 1 dargestellten Schaltung. Die Magnetspule 11 ist als Parallelschaltung einer Kapazität C₁₁ und der Reihenschaltung einer Induktivität L₁₁ sowie eines ohmschen Widerstands R₁₁ dargestellt. In dem Widerstand R₁₁ ist der ohmsche Widerstand der Wicklung der Magnetspule 11 zusammengefaßt. Der kapazitive Anteil der Magnetspule 11 ist in der Kapazität C₁₁ berücksichtigt. Die bidirektionalen Z-Dioden 12, 13 und 14 sind in dem Ersatzschaltbild als Kondensatoren mit den Kapazitäten C₁₂, C₁₃ bzw. C₁₄ dargestellt. Die Kapazitäten C₁₂, C₁₃ und C₁₄ ergeben sich jeweils aus der Reihenschaltung der Sperrschichtkapazitäten der beiden gegeneinander geschalteten Z-Dioden 12a und 12b, 13a und 13b sowie 14a und 14b. Da es sich - wie bereits ausgeführt - bei den bidirektionalen Z-Dioden 12 bis 14 um elektrische Bauelemente in der Form eines Zweipols handelt, lassen sich nur die resultierenden Kapazitäten C₁₂, C₁₃ und C₁₄ meßtechnisch erfassen. Die Gesamtkapazität der Schaltungsanordnung 10 ist mit C_{ges} bezeichnet. Sie ergibt sich zu C_{ges} = C₁₂ + C₁₃ + C₁₄ + C₁₁. Die Messung der elektrischen Werte der Schaltungsanordnung 10 erfolgt über die Anschlüsse 19 und 20.

Das erfindungsgemäße Verfahren beruht auf der Auswertung der Sperrschichtkapazität der bidirektionalen Z-Dioden 12 bis 14. Die Gesamtkapazität C_{ges} der Schaltungsanordnung 10 setzt sich aus der Summe der Kapazitäten C₁₂, C₁₃ und C₁₄ sowie der Kapazität C₁₁ der Magnetspule 11 zusammen. Unter der Voraussetzung, daß die Kapazitäten C₁₂, C₁₃, C₁₄ der drei bidirektionalen Z-Dioden 12 bis 14 praktisch jeweils gleich sind, sind alle drei parallelgeschalteten bidirektionalen Z-Dioden 12 bis 14 dann funktionsfähig, wenn die Gesamtkapazität C_{ges} der Schaltungsanordnung 10 vermindert um die Kapazität C₁₁ der Magnetspule 11 gleich dem dreifachen Wert der Kapazität einer bidirektionalen Z-Diode ist. Ist eine der Z-Dioden 12 bis 14 nicht funktionsfähig, weil sie z. B. nicht richtig eingelötet worden ist oder weil sie beim Einlöten oder beim Vergießen beschädigt worden ist, verringert sich die Gesamtkapazität C_{ges} der Schaltungsanordnung 10 um die Kapazität einer Z-Diode. Sind zwei Z-Dioden nicht funktionsfähig, verringert sich die Gesamtkapazität C_{ges} der Schaltungsanordnung 10 um den doppelten Wert der Kapazität einer Z-Diode. Bei der Ermittlung der Gesamtkapazität C_{ges} sind die Kapazität C₁₁, die Induktivität L₁₁ und der ohmsche Widerstand R₁₁ zu berücksichtigen.

Im Folgenden sind zwei Varianten der Bestimmung der Gesamtkapazität C_{ges} der Schaltungsanordnung 10 beschrieben. In beiden Fällen werden die elektrischen Werte der einzelnen Bauelemente vor dem Einlöten gemessen. Für die spätere Auswertung der Messungen an der vergossenen Schaltungsanordnung 10 sind die Werte der Kapazitäten C₁₂, C₁₃, C₁₄ der bidirektionalen Z-Dioden 12, 13, 14 sowie der Induktivität L₁₁, des ohmschen Widerstands R₁₁ und der Kapazität C₁₁ der Magnetspule 11 vor dem Einlöten erforderlich. Die Amplitude und die Frequenz der Wechselspannungen, die für die Messung der elektrischen Werte der Bauelemente vor dem Einlöten dienen, sind dabei gleich denjenigen gewählt, die zur Messung der elektrischen Werte der vergossenen Schaltungsanordnung verwendet werden. Damit die Z-Dioden beim Messen nicht wirksam werden, ist die Amplitude der Meßspannung kleiner als die Ansprechspannung der Z-Dioden gewählt.

Bei der ersten Variante zur Ermittlung der Gesamtkapazität C_{ges} der Schaltungsanordnung 10 erfolgt die Messung mit einem Kapazitätsmeßgerät, dessen Eingang mit den Anschlüssen 19 und 20 der Schaltungsanordnung 10 verbunden wird. Hierbei ist ein Kapazitätsmeßgerät mit einer hohen Meßfrequenz in der Größenordnung von 1 MHz oder darüber erforderlich, damit der Einfluß der Induktivität L₁₁ auf das Meßergebnis vernachlässigbar klein ist. Bei einer hohen Meßfrequenz ist der Wechselstromwiderstand der an die Leiterbahnen 17 und 18 angeschlossenen Magnetspule 11 sehr groß, die Induktivität L₁₁ wirkt daher wie eine Unterbrechung der Verbindung zwischen den Leiterbahnen 17 und 18. Von dem auf diese Weise ermittelten Wert der Gesamtkapazität C_{ges} der Schaltungsanordnung 10 wird die vor dem Einlöten der Bauelemente in die Schaltungsanordnung 10 gemessene Kapazität C₁₁ der Magnetspule 11 abgezogen und das Ergebnis durch die Anzahl der parallel zu der Magnetspule geschalteten bidirektionalen Z-Dioden geteilt und mit der vor dem Einlöten der Bauelemente in die Schaltungsanordnung 10 gemessenen Kapazität einer bidirektionalen Z-Diode verglichen. Ist die Abweichung gleich Null oder liegt sie innerhalb eines zulässigen Toleranzbereichs, sind alle parallel geschalteten Z-Dioden funktionsfähig. Bei größeren Abweichungen ist mindestens eine Z-Diode nicht funktionsfähig.

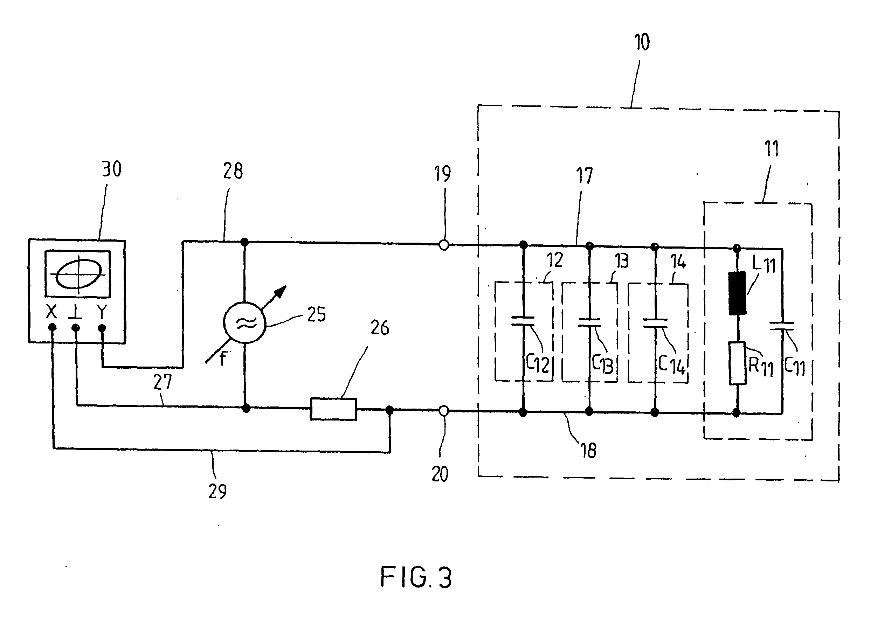

Kapazitätsmeßgeräte mit hoher Meßfrequenz sind teuer. Steht z. B. aus Kostengründen ein derartiges Kapazitätsmeßgerät nicht zur Verfügung, läßt sich die Gesamtkapazität C_{ges} - wie im Folgenden ausgeführt - auch auf andere Weise ermitteln. Bei dieser Variante des erfindungsgemäßen Verfahrens wird von der Überlegung Gebrauch gemacht, daß die Gesamtkapazität C_{ges} der Schaltungsanordnung 10, der Widerstand R₁₁ und die Induktivität L₁₁ einen Schwingkreis bilden. In der Figur 3 ist eine Schaltungsanordnung zur Bestimmung der mit fo bezeichneten Resonanzfrequenz des Schwingkreises dargestellt. Ein Frequenzgenerator 25 ist über einen ohmschen Widerstand 26 an die Anschlüsse 19 und 20 der Schaltungsanordnung 10 angeschlossen. Die Frequenz f des Frequenzgenerators 25 ist innerhalb eines Frequenzbereichs einstellbar, der die Resonanzfrequenz f₀ einschließt. Die Ausgangsspannung des Frequenzgenerators 25 und die an dem Widerstand 26 abfallende Spannung sind über Leitungen 27, 28 und 29 den Eingängen eines Oszilloskops 30 zugeführt. Die an dem Widerstand 26 abfallende Spannung ist ein Maß für den über die Schaltungsanordnung 10 fließenden Strom. Das Potential der Leitung 27 dient als Bezugspotential. Über die Leitung 28 ist die Ausgangsspannung des Frequenzgenerators 25 dem mit dem Buchstaben Y bezeichneten Anschluß für die Vertikalablenkung des Oszilloskops 30 zugeführt. Über die Leitung 29 ist die an dem Widerstand 26 abfallende Spannung dem mit dem Buchstaben X bezeichneten Anschluß für die Horizontalablenkung des Oszilloskops 30 zugeführt. Weicht die Frequenz f des Frequenzgenerators 25 von der Resonanzfrequenz f₀ ab, besteht eine Phasenverschiebung zwischen den den Eingängen X und Y des Oszilloskops 30 zugeführten Spannungen. Die Frequenz f des Frequenzgenerators 25 wird nun so lange geändert, bis die an dem Widerstand 26 abfallende Spannung in Phase mit der Ausgangsspannung des Frequenzgenerators 25 ist. Diese Frequenz ist die Resonanzfrequenz f₀. Aus den Werten der Frequenz f₀, der Induktivität L₁₁ und des Widerstands R₁₁ wird nach den für RLC-Schwingkreise geltenden Beziehungen die Gesamtkapazität C_{ges} der Schaltungsanordnung 10 berechnet. Von diesem Wert wird die Kapazität C₁₁ der Magnetspule 11 abgezogen und das Ergebnis durch die Anzahl der parallel geschalteten bidirektionalen Z-Dioden geteilt. Das Ergebnis dieser Rechnung wird mit der vor dem Einlöten der Bauelemente in die Schaltungsanordnung 10 gemessenen Kapazität einer bidirektionalen Z-Diode verglichen. Ist die Abweichung gleich Null oder liegt sie innerhalb eines zulässigen Toleranzbereichs, sind alle parallel geschalteten Z-Dioden funktionsfähig. Bei größeren Abweichungen ist mindestens eine Z-Diode nicht funktionsfähig. Bei dieser Variante des erfindungsgemäßen Verfahrens ist eine Meßfrequenz in der Größenordnung von 10 kHz ausreichend. Diese Meßfrequenz ist zwei Zehnerpotenzen kleiner als die bei der ersten Variante erforderliche Meßfrequenz.

Mit dem erfindungsgemäßen Verfahren ist es zwar grundsätzlich möglich, die Funktionsfähigkeit einer einzigen Z-Diode, die zu einer Magnetspule parallel geschaltet ist, zu prüfen. Da in der Praxis jedoch aus Sicherheitsgründen jeweils mehrere Z-Dioden parallel zu einander angeordnet sein müssen, ist ein Einsatz von Schaltungen, in denen nur eine einzige Z-Diode parallel zu der Magnetspule geschaltet ist, nicht zulässig.

## Patentansprüche

1. Verfahren zum Nachweis der Funktionsfähigkeit von mehreren gleichen parallel zueinander und zu einer Magnetspule geschalteten Z-Dioden, **dadurch gekennzeichnet, daß** die elektrischen Werte der Z-Dioden (12, 13, 14) und der Magnetspule (11) vor dem Zusammenbau gemessen werden, daß nach dem Zusammenbau die Gesamtkapazität (C_{ges}) der aus der Magnetspule (11) und den Z-Dioden (12, 13, 14) gebildeten Parallelschaltung (10) gemessen wird, daß die Kapazität (C₁₁) der Magnetspule (11) von der Gesamtkapazität (C_{ges}) abgezogen wird, daß der verbleibende Wert durch die Anzahl der Z-Dioden (12, 13, 14) geteilt und das Ergebnis dieser Rechnung mit der Kapazität (C₁₂, C₁₃, C₁₄) einer einzelnen Z-Diode (12, 13, 14) verglichen wird; wobei die Differenz zwischen diesen Werten als Kriterium für die Funktionsfähigkeit der Z-Dioden dient.

2. Verfahren nach Anspruch 1, **dadurch gekennzeichnet, daß** die Messung der Gesamtkapazität (C_{ges}) der Parallelschaltung (10) mit einer Wechselspannung erfolgt, deren Frequenz so groß gewählt ist, daß der Einfluß der Induktivität (L₁₁) der Magnetspule (11) auf das Meßergebnis vernachlässigbar klein ist.

3. Verfahren nach Anspruch 1, **dadurch gekennzeichnet, daß** zur Bestimmung der Gesamtkapazität (C_{ges}) die Resonanzfrequenz (f₀) des aus der Magnetspule (11) und den Z-Dioden (12, 13, 14) gebildeten Schwingkreises (11, 12, 13, 14) gemessen wird und daß die Gesamtkapazität (C_{ges}) aus der Resonanzfrequenz (f₀) und der Induktivität (L₁₁) der Magnetspule (11) sowie deren ohmschen Widerstand (R₁₁) berechnet wird.

## Claims

1. A method for verification of the operability of a plurality of identical zener diodes which are connected in parallel with one another and are connected to a solenoid coil, **characterized by the fact that** the electrical values of the zener diodes (12, 13, 14) and of the solenoid coil (11) are measured before assembly, by the fact that, after assembly, the total capacitance (Cₜₒₜ) of the parallel circuit (10) that is formed from the solenoid coil (11) and the zener diodes (12, 13, 14) is measured, by the fact that the capacitance (C₁₁) of the solenoid coil (11) is subtracted from the total capacitance (Cₜₒₜ) and by the fact that the remaining value is divided by the number of zener diodes (12, 13, 14), and the result of this calculation is compared with the capacitance (C₁₂, C₁₃ C₁₄) of an individual zener diode (12, 13, 14), with the difference between these values being used as a criterion for the operability of the zener diodes.

2. A method according to claim 1, **characterized by the fact that** the measurement of the total capacitance (Cₜₒₜ) of the parallel circuit (10) is carried out using an AC voltage, whose frequency is chosen to be sufficiently large that the influence of the inductance (L₁₁) of the solenoid coil (11) on the measurement result is negligibly small.

3. A method according to claim 1, **characterized by the fact that,** in order to determine the total capacitance (Cₜₒₜ) the resonant frequency (f₀) of the resonant circuit (11, 12, 13, 14) which is formed from the solenoid coil (11) and the zener diodes (12, 13, 14) is measured, and by the fact hat the total capacitance (Cₜₒₜ) is calculated from the resonant frequency (f₀) and the inductance (L₁₁) of the solenoid coil (11) as well as its ohmic resistance (R₁₁).

## Revendications

1. Une méthode de vérification du bon fonctionnement de plusieurs diodes de Zener identiques, branchées en parallèle les unes par rapport aux autres et par rapport à une bobine d'électro-aimant, **caractérisée en ce que** les valeurs électriques des diodes (12, 13, 14) de Zener et de la bobine (11) d'électro-aimant sont mesurées avant assemblage, que la capacité (Cₜₒₜ) totale du branchement (10) en parallèle constitué de la bobine (11) d'électro-aimant et des diodes (12, 13, 14) de Zener est mesurée après assemblage, que la capacité (C₁₁) de la bobine d'électro-aimant est soustraite de la capacité (Cₜₒₜ) totale, que la valeur restante est divisée par le nombre de diodes (12, 13, 14) de Zener et le résultat de cette opération est comparé à la capacité (C₁₂, C₁₃, C₁₄) d'une seule diode (12, 13, 14) de Zener, cependant que la différence entre ces valeurs sert de critère de bon fonctionnement des diodes de Zener.

2. Une méthode selon la revendication n° 1, **caractérisée en ce que** la mesure de la capacité (Cₜₒₜ) totale du branchement (10) en parallèle est effectuée à l'aide d'une tension alternative, dont la fréquence est choisie suffisamment grosse, pour que l'inductance (L₁₁) de la bobine (11) d'électro-aimant n'ait qu'une influence négligeable sur le résultat de mesure.

3. Une méthode selon la revendication n° 1, **caractérisée en ce que** la fréquence (f₀) de résonance du circuit oscillant (11, 12, 13, 14) formé par la bobine (11) d'électro-aimant et les diodes (12, 13, 14) de Zener est mesurée pour déterminer la capacité (Cₜₒₜ) totale et que la capacité (Cₜₒₜ) totale est calculée de la fréquence (f₀) de résonance et de l'inductance (L₁₁) de la bobine (11) d'électro-aimant, ainsi que de sa résistance (R₁₁) ohmique.
